Europäisches Patentamt

(19) European Patent Office

Office européen des brevets

(11) Publication number: **0 052 948**

**A1**

(12) **EUROPEAN PATENT APPLICATION**

(21) Application number: 81305068.9

(22) Date of filing: 27.10.81

(51) Int. Cl.³: **H 01 L 21/76**

(30) Priority: 24.11.80 US 209770

(43) Date of publication of application:
02.06.82 Bulletin 82/22

(84) Designated Contracting States:
DE FR

(71) Applicant: MOTOROLA, INC.
1303 East Algonquin Road
Schaumburg Illinois 60196(US)

(72) Inventor: Krolikowski, Walter F.
11244 North St. Andrews Way
Scottsdale Arizona 85254(US)

(74) Representative: Newens, Leonard Eric et al,
F.J. CLEVELAND & COMPANY 40/43 Chancery Lane
London WC2A 1JQ(GB)

(54) Oxide isolation process.

(57) A method for the construction of oxide-isolated silicon integrated circuit structures is described wherein two pattern-forming means are utilized, the first (40) to provide definition for the etching of silicon tubs (43) and the second (46) to coat the sidewalls (44) of the silicon tubs (43) to control oxidation thereon. When oxidation of the material in the bottom (47) of the tubs (43) is carried out to provide a deep oxide region (50), formation of a ridge or berm at the periphery of the oxide region through excess oxidation of the sidewalls is avoided. The protective coating (48) on the sidewalls (44) is obtained by conformally coating the entire wafer with material having controlled oxidation properties. This coating is subsequently removed at all locations except the sidewalls (44) by anisotropic etching prior to oxidation of the silicon (47).

FIG 3D

FIG 3F

# IMPROVED OXIDE ISOLATION PROCESS

## Technical Field

This invention relates to an improved process for forming integrated circuit structures, and more particularly to an improved process for forming oxide isolated integrated circuit structures.

## Background of the Invention

The advantages of oxide isolated bipolar or MOS integrated circuit structures are well recognized, and include, in particular, increased circuit operating speed and increased packing density. In these structures, isolation between adjacent devices or groups of devices is provided by an isolation oxide which extends through the epitaxial or active layer in which the devices are to be formed, to the underlying substrate. Devices are thus isolated on the edge by the oxide and on the bottom by the interface or junction between the epitaxial (active) layer and the substrate. This may be a p-n junction or a semiconductor-insulator interface depending on the nature of the substrate. Some integrated circuit structures which do not utilize p-n junction isolated substrates, do use thick oxide isolation regions in order to reduce parasitic capacitance of interconnect conductors. It is generally desired to have the surface of the semiconductor including the isolation oxide regions be as flat as possible in order to facilitate interconnection of the different devices.

While the advantages of oxide-isolated structures have been recognized, the available processes have heretofore been deficient in several respects. A particular problem in the prior art which reduces manufacturing yield and reliability, and wastes silicon surface area, has been the formation of ridges or "berms" in the surface at the periphery of the oxide isolation regions. These ridges or berms disturb the otherwise substantially planar characteristics of the surface and make it more difficult to achieve consistent and reliable interconnection of the devices so isolated. In addition, the berms occupy considerable lateral area so that device packing density is reduced. These berms at the periphery of the oxide isolation regions come about as the result of the simultaneous oxidation of the sidewalls and the bottoms of the "tubs" in which the isolation oxidation is performed. Oxidation of the sidewalls also produces the undesirable lateral spreading of the tub shape.

Prior art attempts to eliminate these berms at the periphery of the oxide isolation tubs have not been entirely successful. For example, I. Magdo et al, _J. Electrochem. Soc.: Solid-State Science and Technology_, Vol. 125, No. 6, pg. 932, June 1978, disclose a process which reduces but does not eliminate the berms. Also, costly additional process steps are used, and even though area spreading is reduced, area wastage is not reduced because an extra alignment tolerance is required. Thus a need for an improved process has continued to exist.

Accordingly, it is an object of this invention to provide an improved process for fabricating oxide isolated device structures.

It is a further object of this invention to provide a process for fabricating oxide-isolated device structures of improved reliability and yield.

It is an additional object of this invention to provide a process for fabricating oxide isolated structures wherein the difference in size (lateral spreading) between the initial shape determining pattern and the final oxide isolation region is made smaller than the prior art.

It is an additional object of this invention to provide a process for fabricating oxide isolated structures which occupy less total area than required in the prior art.

It is a further object of this invention to provide a process for fabricating oxide isolated structures having higher packing density.

It is an additional object of this invention to provide a process for fabricating oxide isolated structures of improved surface planarity.

It is a still further object of this invention to provide an improved process for fabricating oxide isolated structures without resort to additional mask alignment steps.

## SUMMARY OF THE INVENTION

In a preferred embodiment of the invention, a silicon wafer is coated with a pattern-forming means and apertures defined therein in the shape of the desired oxide isolation regions. Tubs are etched in the exposed silicon so that a slight undercutting of the pattern-forming means is obtained at the edges of the tubs. A second pattern-forming means is then deposited conformally over the entire surface. The coated wafer is exposed to an anisotropic etchant means which removes the second pattern forming means from the bottom of the tubs, but incompletely from the sidewalls of the tubs where it is protected by the slight overhang of the first pattern-forming means. The wafer is then oxidized by methods well known per se in the art until the oxide formed has filled the etched tubs to a level substantially planar with the adjacent wafer surface. The presence of the second pattern forming means on the sidewalls of the tubs controls oxidation thereon so that the ridge or berm at the edge of the tubs is substantially eliminated. Avoidance of the ridge or berm at the periphery of the oxide isolation regions eliminates a significant cause of weak spots or short circuits which can occur in interconnection metallization and dielectric layers which cross this region. The increase in lateral dimensions of the oxide isolation tub during oxidation is much reduced over the prior art without increasing the number of mask alignments.

## BRIEF DESCRIPTION OF THE DRAWINGS

FIG. 1 is a cross-section in schematic form of a partially completed oxide isolated integrated circuit structure showing the surface contour that is desired ideally to be obtained;

FIG. 2A-D are cross-sections of a partially completed oxide isolated integrated circuit structure according to the prior art methods;

FIG. 3A-F are cross-sections of partially completed oxide isolated integrated circuit structures at various stages of the process in accordance with one of the embodiments of the invention.

## DETAILED DESCRIPTION OF THE PREFERRED EMBODIMENTS

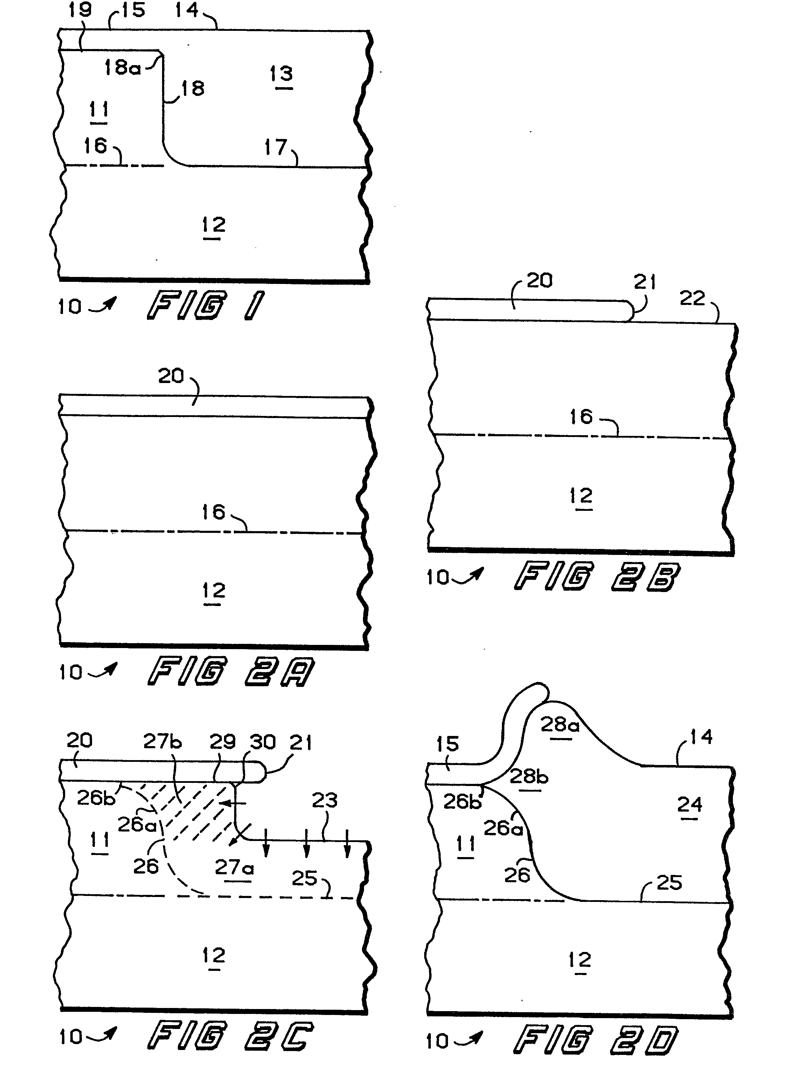

FIG. 1 is a schematic illustration of a desired result of an oxide isolation process. Silicon semiconductor body 10 is oxidized in region 13 so as to form a silicon pedestal 11 surmounting substrate 12 in such a way that surface 14 of the oxide region 13 is substantially coplanar with surface 15 above silicon pedestal 11. During subsequent processing steps, a variety of semiconductor devices can be built in pedestal 11. Substrate 12 may be of the same or different conductivity type than pedestal 11 or may be an insulating material. It is generally desired to have interface region or junction 16 between pedestal 11 and substrate 12 intersect sidewall 18 or bottom 17 of oxide isolation region 13. It is further desired that pedestal corner 18a have a small radius of curvature so that pedestal surface 19 has the largest possible unperturbed area in which to construct devices.

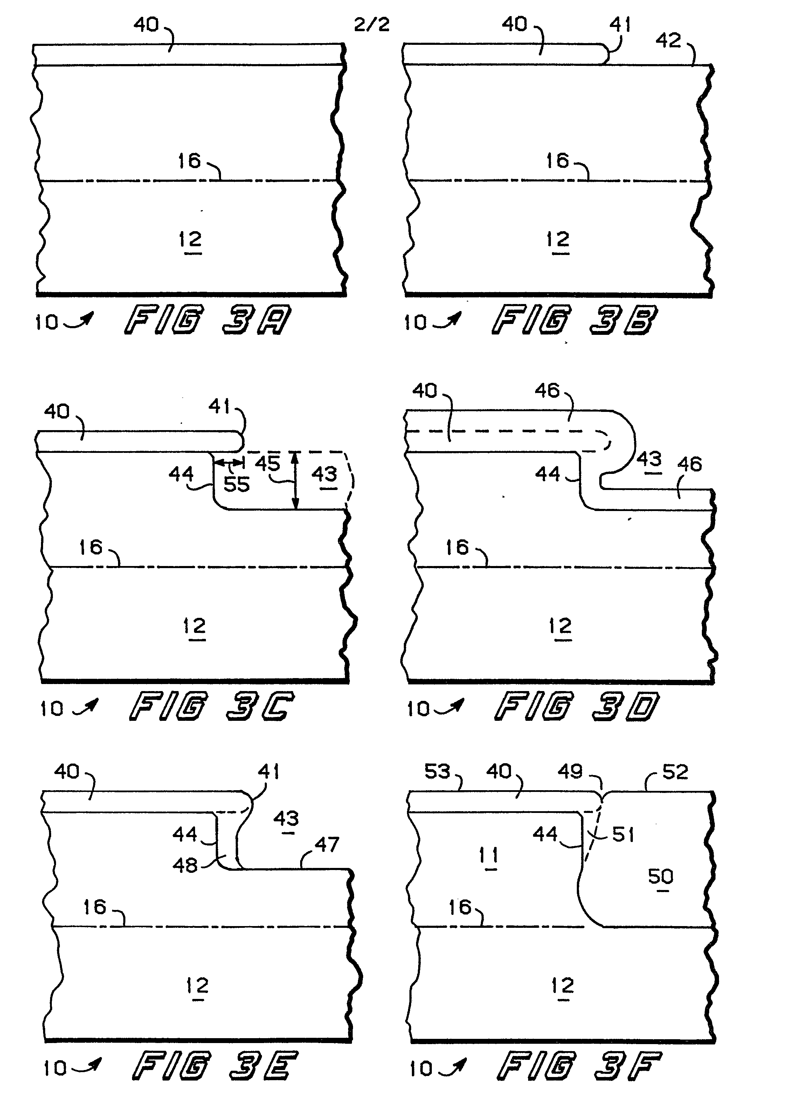

FIG. 2A-D illustrates a prior art method for forming oxide isolation structure. Silicon wafer body 10 is coated with pattern-forming layer or means 20 (FIG. 2A) in which a pattern has been delineated at edge 21 to expose silicon surface 22 (FIG. 2B). Silicon is removed by etching using techniques well known per se in the art to form a tub having contour 23 (FIG. 2C). The silicon exposed in tub 23 is then oxidized to form oxide region 24 whose surface 14 over the central regions of the tub is approximately coplanar with surface 15 over the pedestal region 11 (FIG. 2D). During the oxidation process, silicon is consumed in forming the oxide so that tub contour 23 advances approximately isotropically into the body of the semiconductor as shown by the arrows on FIG. 2C, reaching contour 25-26. Depth 25 is such that the newly created oxide 24 substantially fills tub 23 and compensates for silicon region 27a consumed in the oxidation process. However, oxidation of sidewall region 27b creates additional oxide adjacent to edge 21 of pattern forming layer 20 with the result that ridge 28a-b of additional oxide is formed which protrudes from the surface at the perimeter of the tub regions. The height and lateral extent of this ridge or berm 28a-b is significant compared to other dimensions of the typical device structure, and is hence a serious impediment to compact device layout and obtaining reliable device interconnections. It is well known that breaks and/or short circuits frequently occur when metal interconnects and/or dielectric layers cross such protrusions. Hence, eliminating a cause of breaks and/or shorts improves manufacturing yield and reliability.

The lateral extent of berm 28a-b is relatively large because oxidation tends to proceed more rapidly at interface 29 between the silicon surface and pattern forming layer or means 20 when oxide is used therein. As a result, corner 30 between pedestal 11 and tub 23 is rounded to contour 26a-b by encroachment of thick oxide 28b during the oxidation process, rather than retaining the desired shape shown at 18a, FIG. 1. Thus the space available on pedestal 11 to build devices is reduced by an amount corresponding to the lateral oxidation from corner 30 to intersection 26b.

FIG. 3A-F illustrates the practice of the method of this invention according to the preferred embodiment. Silicon wafer body 10 is first coated by pattern-forming layer or means 40 which is resistant to oxidation and silicon etching (FIG. 3A). A desired aperture pattern of perimeter P at 41 is formed so as to expose silicon surface 42 wherein an oxide isolation region is desired to be formed (FIG. 3B). Silicon surface 42 is etched by methods well known per se in the art to form tub region 43 of depth 45 (FIG. 3C). It is convenient to use an etching process which etches laterally as well as vertically so that sidewall 44 of tub 43 under-cuts first pattern-forming means 40 by undercut 55 from aperture edge 41. Obtaining undercut 55 is important to the practice of this invention. It must be sufficient to shadow sidewall 44 during a subsequent anisotropic etching step, and its optimum value can be determined experimentally for any given choice of materials, tub depth, etch and oxidation conditions. Values of undercut 55 larger than one-fourth but smaller than twice tub depth 45 are useful, but values approximately comparable to tub depth 45 were found to be convenient. Different etch solutions and crystal orientations provide varying degrees of etch anisotropy so that undercut 55 may be varied with respect to tub depth 45. Because of this undercut, the projected area of the tub exceeds the area of the aperture pattern by an amount given approximately by the product of the undercut amount and the perimeter P.

In the practice of this invention, it has been found convenient to form the first pattern-forming means 40 out of a sandwich of two materials: a layer of silicon dioxide of 100 to 5000 Angstroms ($10^{-8}$ to $5 \times 10^{-7}$m) thickness, typically 1000 Angstroms ($10^{-7}$m), directly on the silicon surface, followed by a layer of silicon nitride of 500 to 5000 Angstroms ($5 \times 10^{-8}$ to $5 \times 10^{-7}$m) thickness, typically 1500 Angstroms ($1.5 \times 10^{-7}$m), both formed by methods well known per se in the art.

A second pattern-forming means or layer 46 is deposited over the patterned and etched silicon body as in FIG. 3D in such a way as to conformally coat the surface including sidewalls 44 of tub 43. Pattern-forming means 46 must be capable of controlling the oxidation of selected portions of the silicon surface. Its oxidation rate must be less than that of silicon. Silicon nitride in the thickness range 100-500 Angstroms ($1-5 \times 10^{-8}$m) is utilized and 200-300 Angstroms ($2-3 \times 10^{-8}$m) is found to give the most satisfactory results for the oxidation conditions subsequently used. The desired thickness depends on the mode of oxidation utilized and tub depth 45.

Pattern forming means 46 is anisotropically etched (FIG. 3E) to remove material principally from the major surfaces of the wafer so as to expose surface 47 in the bottom of tub 43, but leave sidewall 44 of tub 43 coated by region 48 as a result of shadowing by edge 41 of pattern-forming layer 40 during the anisotropic etch.

Ion milling is a desirable anisotropic etch technique useful in the practice of this invention. Angles of incidence of 0-60° with respect to the surface normal are useful, with 30°-60° preferred and 45° being a convenient value. Using different angles of incidence permits region 48 to be tapered, a desirable control feature. Other anisotropic etch techniques such as, for example, reactive ion etching or plasma etching, well known per se in the art, are also useful. No additional mask alignment step is required to define the required pattern in the second pattern forming means since alignment with the aperture of the first layer is automatic. Region 48 is protected automatically by undercut 55 during the anisotropic etch.

The purpose of region 48 is to control the oxidation of sidewall 44 during the subsequent oxidation step so that the growth of excess oxide on sidewall 44 is avoided. The original thickness of layer 46 and the anisotropic etching process are adjusted so as to leave just sufficient residual material 48 on the sidewall 44 so that region 48 is converted to an oxide-nitride mixture, preferably an oxide, during the subsequent oxidation step, becoming region 51 (FIG. 3F). The degree of conversion must be sufficient so that oxidized region 51 is compatible with growing oxide region 50, to form a void free substantially homogeneous region 50-51. High pressure oxidation at ten atmospheres in $H_2O$ at 920°C is a preferred method of obtaining oxide region 50-51 of 15000 Angstroms $(1.5 \times 10^{-6}m)$ typical thickness.

Use of the above-described procedure results in oxide region 50-51 whose surface 52 is substantially coplanar with adjacent surface 53 over silicon pedestal 11, joining at intersection 49 which is substantially the edge of the original contour 41 of the first pattern-forming layer. If second pattern forming layer 46 and region 48 are too thin, then too much sidewall oxidation will occur and a berm will form at intersection 49; if too thick, then too little sidewall oxidation will occur and a crevice will form at intersection 49.

The conversion rate of the silicon nitride used for layer 46 and region 48 to oxide during the oxidation step depends on the oxidation procedure utilized. The conversion (oxidation) rate of the material of region 48 is much less than the oxidation rate of silicon, and substantially complete conversion of the relatively thin film (e.g. less than 500 Angstroms; $5 \times 10^{-8}$m) occurs in the same time as the growth of a much thicker oxide region (e.g. 15,000 Angstroms; $1.5 \times 10^{-6}$m) in the bottom of the tub. The proper combination of materials, layer thickness, anisotropic etching procedure and oxidation cycle necessary to obtain a substantially planar surface can be readily determined by experiment for any combination of desired final oxide thickness and oxidation technique.

The actual displacement (lateral spreading) of sidewall 44 from pattern edge 41 (FIG. 3F) is significantly smaller with the invented method than the distance between sidewall intersection 26b and pattern edge 21 in the prior art as shown in FIG. 2C-D. This improvement is of significant aid in the design, layout, and realization of high density circuitry where minimum dimensions are desired to be used to achieve higher packing density. Unlike prior art attempts to reduce lateral spreading, no additional mask alignments are used and no space need be left for mask alignment tolerances.

Thus, it is apparent that there has been provided in accordance with this invention an improved method for the fabrication of oxide isolated structures of improved surface planarity. Higher fabrication yields and greater reliability can be expected as a result of elimination of berms and/or fissures at the periphery of the oxide isolation region. Lateral pattern spreading is reduced without additional alignments so that circuit packing density can be increased and less total area utilized.

While the invention has been described in terms of certain recommended materials for the two pattern-forming layers and recommended methods for anisotropic etching of the pattern-forming layers, it will be obvious to those skilled in the art that the invented method is useful with other materials and techniques and a wide variety of device geometries and structures which may differ in detail but preserve the central relationships which inhibit sidewall

-10-

oxidation and lateral spreading of the etched tubs. Also, the invented procedures apply to silicon regions which may have been formed as islands upon a non-silicon insulating substrate. Accordingly, it is intended to encompass all such variations as fall within the scope of the invention.

CLAIMS

1.    A method for forming in a major surface of a silicon wafer at least one oxide region of a predetermined shape whose exterior surface is substantially flat and coplanar with adjacent regions of said major surface, comprising:

forming on said major surface a first pattern-forming means (40) resistant to silicon etching and oxidation;

forming therein a first pattern shape (41) of perimeter P corresponding, within a predetermined etch undercut (55), substantially to said predetermined shape;

removing therefrom said first pattern shape so as to expose an underlying silicon region (42) substantially corresponding to said first pattern shape (41);

etching said underlying silicon region (42) perpendicularly to said major surface to a predetermined bottom depth (45), and laterally parallel to said major surface by said predetermined etch undercut (55) from said perimeter P, so as to form a tub region (43) having a bottom region (47) and a sidewall region (44);

depositing conformally thereon a second pattern-forming means (46) having an oxidation rate less than silicon;

removing selectively said second pattern forming means (46) so as to expose said bottom region (47) to subsequent oxidation, but leave a sufficient thickness (48) of said second pattern forming means (46) remaining on said sidewall region (44) to control oxidation thereon;

forming said oxide region (50-51) in said tub region;

continuing until said exterior surface (52) of said oxide region (50-51) formed in said tub region is substantially flat and coplanar with said adjacent regions (53) of said major surface.

2.    The method of claim 1 wherein said predetermined etch undercut (55) is larger than one-fourth but less than twice said predetermined bottom depth (45), and wherein said selective removal of said second pattern-forming means (46) is accomplished by an anisotropic etching means.

3.    The method of claim 2 wherein said anisotropic etching means is ion milling, and wherein said ion milling takes place at an angle of incidence, measured with respect to a surface normal, of not more than 60 degrees.

4.    The method of claim 1, or 2, or 3 wherein said first pattern-forming means (40) consists essentially of a sandwich of a layer of silicon dioxide formed on said silicon wafer and a layer of silicon nitride formed on said layer of silicon dioxide, and wherein said second pattern-forming means (46) consists essentially of silicon nitride.

5.    The method of claim 4 wherein said layer of silicon dioxide has a thickness in the range 100 to 5000 Angstroms ($10^{-8}$ to $5 \times 10^{-7}$m), and said layer of silicon nitride has a thickness in the range of 500 to 5000 Angstroms ($5 \times 10^{-8}$ to $5 \times 10^{-7}$m), and wherein said sufficient thickness (48) of said second pattern forming means (46) remaining on said sidewall region (44) of said tub region (43) is in the range 100-500 Angstroms ($10^{-8}$ to $5 \times 10^{-8}$m).

6.    A product formed using the process of claim 1.

0052948

1/2

FIG 1

FIG 2A

FIG 2B

FIG 2C

FIG 2D

FIG 3A

FIG 3B

FIG 3C

FIG 3D

FIG 3E

FIG 3F

| | | | Application number |
|---|---|---|---|
| European Patent Office | EUROPEAN SEARCH REPORT | | EP 81 30 5068.9 |

| DOCUMENTS CONSIDERED TO·BE RELEVANT | | | CLASSIFICATION OF THE APPLICATION (Int. Cl.³) |
|---|---|---|---|
| Category | Citation of document with indication, where appropriate, of relevant passages | Relevant to claim | |
| X | JOURNAL OF THE ELECTROCHEMICAL SOCIETY Vol. 127, No. II, November 1980, Manchester KAHNG et al. "A Method for Area Saving Planar Isolation Oxides Using Oxidation Protected Sidewalls" pages 2468 to 2471 * page 2468, first paragraph to page 2469, first paragraph; page 2470, second paragraph * -- | 1,2,4, 5 | H 01 L 21/76 |
| X | US - A - 3 966 514 (FENG et al.) * column 4, line 35 to column 7, line 10; fig. * -- | 1,2,4 | TECHNICAL FIELDS SEARCHED (Int. Cl.³) H 01 L 21/76 |
| X | IBM TECHNICAL DISCLOSURE BULLETIN Vol. 22, No. 7, December 1979 New York BENJAMIN "Self-aligned Recessed Oxide Isolation Process/Structure To Minimize "Bird's Beak" Formation" pages 2749 to 2750 -- | 1,2,4 | |
| A | SOLID STATE TECHNOLOGY, Vol. 21, No. 12 December 1978, Port Washington ROBERTSON "Advances in Ion Beam Milling" pages 57 to 60 ---- | 3 | CATEGORY OF CITED DOCUMENTS X: particularly relevant A: technological background O: non-written disclosure . P: intermediate document T: theory or principle underlying the invention E: conflicting application D: document cited in the application L: citation for other reasons &: member of the same patent family, corresponding document |

| | The present search report has been drawn up for all claims | | |
|---|---|---|---|
| Place of search | Date of completion of the search | Examiner | |
| Berlin | 16-02-1982 | GIBBS | |

EPO Form 1503.1  06.78